# FASCICULE DE BREVET EUROPEEN

(11) **EP 1 922 732 B1**
(45) Date de publication et mention de la délivrance du brevet: **17.12.2008**
(21) Numéro de dépôt: 06794358.9
(22) Date de dépôt: 25.08.2006
(51) Int. Cl.: G11C 5/14

(54) **CIRCUIT INTEGRE SANS CONTACT PASSIF COMPRENANT UN DRAPEAU DE SURVEILLANCE D'UNE TENSION D'EFFACEMENT-PROGRAMMATION**
PASSIVE KONTAKTFREIE SCHALTUNG MIT EINER FLAG ZUM ÜBERWACHEN EINER LÖSCHPROGRAMMIERSPANNUNG
PASSIVE CONTACT-FREE INTEGRATED CIRCUIT COMPRISING A FLAG FOR MONITORING AN ERASING-PROGRAMMING VOLTAGE

(30) Priorité: 06.09.2005 FR 0509081
(43) Date de publication de la demande: 21.05.2008
(73) Titulaire: STMicroelectronics SA, 92120 Montrouge (FR)
(72) Inventeur: NAURA, David, 13100 Aix en Provence (FR); MOREAUX, Christophe, 13109 Simiane (FR); KARI, Ahmed, 83170 Tourves (FR); RIZZO, Pierre, 13100 Aix en Provence (FR)
(74) Mandataire: Marchand, André
(86) Numéro de dépôt international: PCT/FR2006/001985
(87) Numéro de publication internationale: WO 2007/028872

(56) Documents cités:
- US-A- 5 394 105
- US-A- 5 449 894
- US-A- 5 982 647
- US-A1- 2005 162 145
- US-B1- 6 288 629
- US-B1- 6 437 609

## Description

La présente invention concerne un circuit intégré sans contact comprenant une mémoire de données et un circuit survolteur à accumulation de charges pour fournir une haute tension nécessaire à l'écriture de données dans la mémoire.

La présente invention concerne plus particulièrement un circuit intégré sans contact de type passif, alimenté électriquement par une tension produite à partir d'un signal d'antenne.

Les circuits intégrés sans contact passifs sont généralement destinés aux applications RFID (Radio Frequency Identification) et peuvent être du type à couplage inductif ou du type "à couplage électrique".

Les circuits intégrés passifs du premier type comprennent une bobine d'antenne, émettent des données par modulation de charge et sont alimentés par couplage inductif en présence d'un champ magnétique dont la fréquence est généralement de l'ordre de la dizaine de MHz. De tels circuits intégrés sont par exemple décrits par les normes ISO/IEC 14443A/B, ISO/IEC 13693 qui prévoient une fréquence de travail de 13,56 MHz.

Les circuits intégrés passifs du second type sont alimentés électriquement par un champ électrique UHF oscillant à plusieurs centaines de MHz, et émettent des données par modulation du taux de réflexion de leur circuit d'antenne (technique appelée "backscattering"). De tels circuits intégrés sont par exemple décrits par la spécification industrielle EPCTM-GEN2 (*"Radio-Frequency Identity Protocols Class-1 Generation-2 - UHF RFID Protocol* for *Communications* at *860 MHz - 960 MHz"*) en cours de normalisation. Ils sont généralement utilisés dans les applications dites à longue portée ("long range"), dans lesquelles la distance entre le circuit intégré et une station d'émission/réception de données émettant le champ électrique, appelée communément un lecteur, peut atteindre plusieurs mètres.

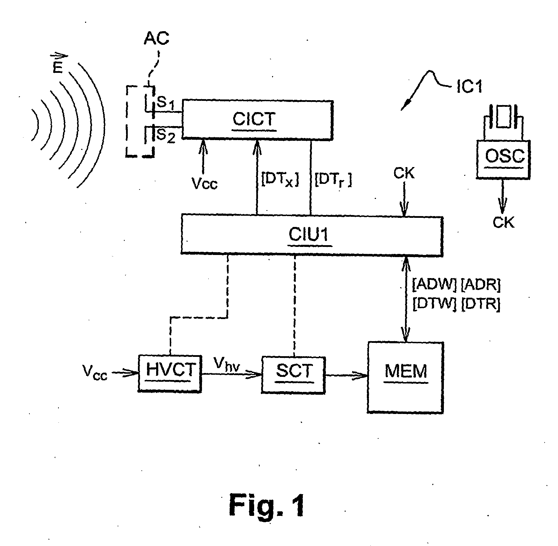

La figure 1 représente schématiquement l'architecture d'un circuit intégré IC1 du second type. Le circuit intégré comprend un circuit d'antenne dipolaire AC, un circuit d'interface de communication CICT, une unité de contrôle CTU1, une mémoire non volatile MEM de type EEPROM (effaçable et programmable électriquement), un circuit survolteur HVCT à accumulation de charges et un oscillateur OSC fournissant un signal d'horloge CK à l'unité CTU1.

Le circuit CICT assure la réception et la transmission de données via le circuit d'antenne. Il reçoit de l'unité de contrôle CTU1 des données DTx à émettre via le circuit d'antenne ou fournit à l'unité CTU1 des données DTr reçues via le circuit d'antenne. Il fournit également une tension Vcc assurant l'alimentation électrique du circuit intégré et généré à partir de signaux d'antenne S1, S2 apparaissant dans le circuit d'antenne AC en présence d'un champ électrique E émis par un lecteur (non représenté). La tension Vcc est typiquement de l'ordre du Volt à quelques Volt.

Le circuit survolteur HVCT fournit, à partir de la tension Vcc, une haute tension Vhv nécessaire à des opérations d'écriture de données dans la mémoire, typiquement de l'ordre de 10 à 15 V. La tension Vhv est généralement appliquée à la mémoire par l'intermédiaire d'un circuit interrupteur SCT qui est contrôlé par l'unité CTU1.

Lorsqu'une commande d'écriture est reçue, l'unité CTU1 active le circuit survolteur HVCT, applique à la mémoire MEM une adresse d'écriture ADW et des données à écrire DTW, puis active le circuit interrupteur SCT pour qu'une impulsion de tension Vpp soit appliquée à la mémoire. Ces opérations peuvent être répétées plusieurs fois en fonction du nombre de cycles d'écriture à réaliser, en laissant le circuit survolteur activé.

Un inconvénient d'un tel circuit intégré, inhérent à son caractère passif, est que la tension d'alimentation Vcc peut présenter des affaiblissements critiques dues à des fluctuations de l'intensité du champ électrique E dont elle est extraite.. Un inconvénient similaire est constaté avec les circuits intégrés passifs à couplage inductif, lorsque l'intensité du champ magnétique et/ou le taux de couplage inductif avec le lecteur sont insuffisants. De tels affaiblissements se produisent par exemple lorsque l'utilisateur du circuit intégré, par exemple le détenteur d'une carte à puce sans contact comprenant le circuit intégré, éloigne la carte/le circuit intégré du lecteur pendant une communication entre le lecteur et le circuit intégré. Ces affaiblissements de la tension d'alimentation sont problématiques lorsqu'ils se produisent pendant l'écriture de données dans la mémoire, car ils peuvent affecter la haute tension Vhv. Ainsi, si la tension Vhv présente un niveau insuffisant lorsque le circuit intégré déclenche l'écriture de la mémoire, des cellules mémoire risquent de ne pas recevoir les données prévues ou risquent d'être placés dans un état intermédiaire qui n'est ni l'état programmé ni l'état effacé, correspondant à une corruption des données stockées dans les cellules mémoire.

Le brevet US 6 288 629 propose de surveiller la tension d'alimentation Vcc quand des données sont écrites dans la mémoire, et de lever un drapeau indicateur lorsque la tension Vcc fluctue en dessous d'un seuil critique pendant la phase d'écriture. Lorsque la phase d'écriture est achevée, le circuit intégré lit le drapeau et, si le drapeau indique que la tension Vcc est devenue inférieure au seuil critique pendant la phase d'écriture, le circuit intégré communique cette information au lecteur ayant émis la commande d'écriture.

Selon des études conduites par les auteurs de la présente invention, incluant diverses simulations visant à observer le comportement d'un circuit intégré sans contact dans des conditions de fonctionnement correspondant à des applications concrètes, cette méthode peut conduire à diagnostiquer qu'une opération d'écriture est défectueuse alors qu'elle s'est déroulée correctement. Il apparaît en effet que, dans de nombreuses conditions de fonctionnement, la tension d'alimentation Vcc peut présenter des affaiblissements, voire des microcoupures de courte durée, qui n'affectent pas le processus d'écriture.

La présente invention vise ainsi à améliorer le diagnostic de défaillance d'une opération d'écriture, afin qu'une opération d'écriture qui s'est déroulée correctement ne soit pas considérée comme défectueuse au seul motif que la tension d'alimentation Vcc est passée en dessous d'un certain seuil au cours de ses fluctuations.

La présente invention se base sur le constat que, dans la majorité des situations et des conditions de fonctionnement, une opération d'écriture peut être valablement effectuée quand le circuit survolteur a accumulé des charges électriques en quantité suffisante pour lui permettre de mener à bien cette opération d'écriture. Selon l'invention, cette condition est remplie quand la haute tension Vhv fournie par le circuit survolteur a atteint un seuil qualifié de "critique". Ainsi, selon l'invention, on prévoit un drapeau indicateur qui, au lieu d'être fonction de la tension d'alimentation, est fonction de la valeur de la haute tension fournie par le circuit survolteur. Ce drapeau indicateur est utilisable pour post-diagnostiquer une opération écriture, mais est également utilisable à d'autres fins, comme cela apparaîtra dans ce qui suit.

Plus particulièrement, la présente invention prévoit un circuit intégré passif sans contact comprenant une mémoire de données non volatile programmable électriquement, un circuit survolteur à accumulation de charges pour fournir une haute tension nécessaire à l'écriture de données dans la mémoire, un point mémoire volatile pour mémoriser un drapeau indicateur, et des moyens pour modifier la valeur du drapeau indicateur lorsque la haute tension atteint la première fois un seuil critique après activation du circuit survolteur.

Selon un mode de réalisation, le circuit intégré comprend un circuit interrupteur pour appliquer la haute tension à la mémoire et des moyens pour empêcher le circuit interrupteur d'appliquer la haute tension à la mémoire tant que la haute tension n'a pas atteint le seuil critique après activation du circuit survolteur.

Selon un mode de réalisation, le circuit interrupteur comprend un générateur de rampe pour fournir progressivement la haute tension à la mémoire.

Selon un mode de réalisation, le circuit intégré comprend une unité de contrôle configurée pour exécuter une commande d'écriture d'une donnée dans la mémoire puis émettre un message d'information spécifique quand le drapeau indique que la haute tension n'a pas atteint le seuil critique pendant l'exécution de la commande d'écriture.

Selon un mode de réalisation, le circuit intégré comprend une unité de contrôle configurée pour effectuer de façon inconditionnelle les actions suivantes, en réponse à une commande d'écriture d'une donnée dans la mémoire: appliquer un signal d'activation au circuit survolteur pour qu'il produise la haute tension, appliquer à la mémoire une adresse d'écriture et une donnée à écrire, et appliquer un signal d'activation à un circuit interrupteur fournissant la haute tension à la mémoire.

Selon un mode de réalisation, le circuit intégré comprend une unité de contrôle configurée pour effectuer les actions suivantes, sur réception d'une commande d'écriture d'une donnée dans la mémoire : appliquer un signal d'activation au circuit survolteur, pour qu'il produise la haute tension, appliquer à la mémoire une adresse d'écriture et la donnée à écrire, si la haute tension atteint le seuil critique, appliquer un signal d'activation à un circuit interrupteur fournissant la haute tension à la mémoire, et si la haute tension n'a pas atteint le seuil critique au terme d'un intervalle de temps déterminé, ne pas appliquer le signal d'activation au circuit interrupteur et émettre un message d'information spécifique indiquant que la haute tension n'a pas été appliquée à la mémoire.

Selon un mode de réalisation, le circuit intégré comprend un circuit détecteur qui surveille la haute tension et fournit un signal de détection dont la valeur indique si la haute tension est inférieure au seuil critique ou est supérieure ou égale au seuil critique.

Selon un mode de réalisation, le circuit intégré comprend un circuit régulateur fournissant un signal de régulation du circuit survolteur ayant une valeur active chaque fois que la haute tension est supérieure ou égale à un seuil de régulation.

Selon un mode de réalisation, le seuil critique est égal au seuil de régulation.

Selon un mode de réalisation, le signal de régulation et le signal de détection sont confondus.

Selon un mode de réalisation, le drapeau indicateur est mémorisé par une bascule comprenant une première entrée de contrôle pour conférer au drapeau une première valeur signifiant que la haute tension a atteint le seuil critique, et une seconde entrée de contrôle pour conférer au drapeau une seconde valeur signifiant que la haute tension n'a pas atteint le seuil critique.

Selon un mode de réalisation, la première entrée de contrôle de la bascule reçoit le signal de détection.

Selon un mode de réalisation, la seconde entrée de la bascule reçoit au moins l'un des deux signaux suivants : un signal de désactivation du circuit survolteur et/ou un signal de remise à zéro du circuit intégré.

L'invention concerne également un objet portatif électronique de type carte à puce ou étiquette électronique, comprenant un support portable et un circuit intégré selon l'invention monté sur le support portable ou intégré dans le support portable.

L'invention concerne également un procédé d'écriture d'une donnée dans une mémoire non volatile programmable électriquement d'un circuit intégré sans contact passif, comprenant les étapes consistant à initialiser un drapeau indicateur dans un point mémoire volatile du circuit intégré, activer un circuit survolteur à accumulation de charges fournissant une haute tension nécessaire à l'écriture de la donnée dans la mémoire, et changer la valeur du drapeau indicateur lorsque la haute tension atteint la première fois un seuil critique après activation du circuit survolteur.

Selon un mode de réalisation, la haute tension n'est pas appliquée à la mémoire tant qu'elle n'atteint pas le seuil critique.

Selon un mode de réalisation, le procédé comprend l'exécution inconditionnelle d'étapes prédéfinies visant à écrire la donnée dans la mémoire, puis l'envoi d'un message d'information relatif à la valeur du drapeau indicateur si le drapeau indique que la haute tension n'a pas atteint le seuil critique pendant la réalisation des étapes prédéfinies.

Selon un mode de réalisation, le procédé comprend une étape de régulation de la haute tension au voisinage d'un seuil de régulation.

Selon un mode de réalisation, le seuil critique est égal au seuil de régulation.

Selon un mode de réalisation, le drapeau indicateur est géré au moyen d'une bascule comprenant une entrée de contrôle à laquelle est appliqué un signal de détection dont la valeur indique si la haute tension est inférieure au seuil critique ou est supérieure ou égale au seuil critique.

Selon un mode de réalisation, la bascule est remise à zéro quand le circuit survolteur n'est pas actif.

Ces objets, caractéristiques et avantages ainsi que d'autres de la présente invention seront exposés plus en détail dans la description suivante d'un exemple de réalisation d'un circuit intégré sans contact passif selon l'invention, faite à titre non limitatif en relation avec les figures jointes parmi lesquelles :
- la figure 1 précédemment décrite représente schématiquement l'architecture d'un circuit intégré sans contact comprenant une mémoire non volatile,
- la figure 2 représente l'architecture d'un circuit intégré sans contact selon l'invention, comprenant une mémoire non volatile et des moyens pour diagnostiquer une défaillance dans le processus d'écriture de la mémoire,
- les figures 3A à 3E représentent divers signaux électriques apparaissant dans le circuit de la figure 2 pendant l'écriture de données dans la mémoire,
- la figure 4 est un organigramme décrivant dès opérations effectuées par le circuit intégré de la figure 1 sur réception d'une commande d'écriture de la mémoire,
- la figure 5 illustre un exemple de réalisation d'une pompe de charges représentée sous forme de bloc en figure 2,
- la figure 6 illustre un exemple de réalisation d'un détecteur de seuil représenté sous forme de bloc en figure
- la figure 7 illustre un exemple de réalisation d'un point mémoire volatile représenté sous forme de bloc en figure 2, recevant un drapeau indicateur selon l'invention,
- la figure 8 illustre un exemple de réalisation d'une mémoire non volatile représentée sous forme de bloc en figure 2, et
- la figure 9 illustre un exemple de réalisation d'une cellule mémoire non volatile présente dans la mémoire de la figure 8.

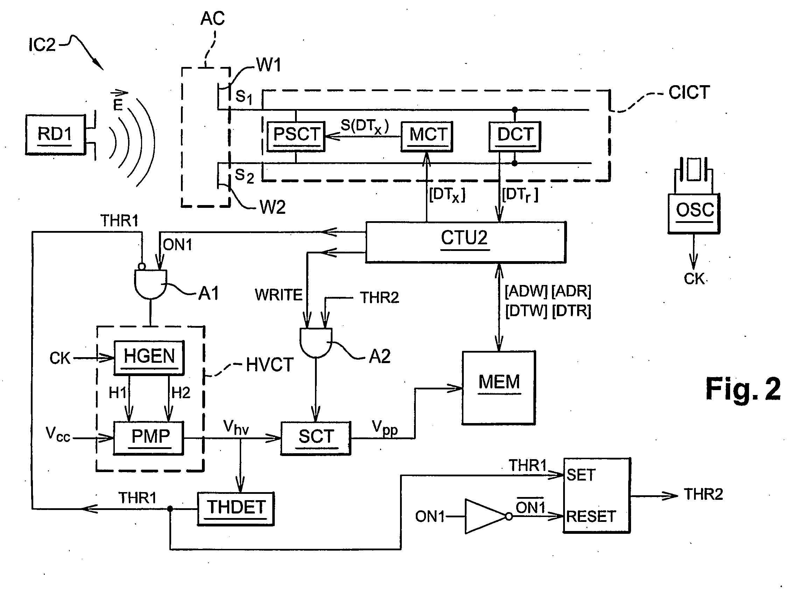

Le circuit intégré IC2 représenté en figure 2 comprend de façon classique un circuit d'antenne AC, un circuit d'interface de communication CICT, une unité de contrôle CTU2, une mémoire MEM de type EEPROM (effaçable et programmable électriquement), un circuit survolteur HVCT et un oscillateur OSC fournissant un signal d'horloge CK à l'unité CTU1.

Le circuit d'antenne comprend ici deux brins conducteurs W1, W2 formant un dipôle. En présence d'un champ électrique E émis par un lecteur RD1 représenté schématiquement, des signaux d'antenne alternatifs S1, S2 de faible amplitude (quelques dixièmes de Volt) apparaissent sur les brins conducteurs W1, W2.

Le circuit CICT comprend un circuit d'alimentation électrique PSCT, un circuit de modulation MCT et un circuit de démodulation DCT. Le circuit PSCT fournit une tension Vcc assurant l'alimentation électrique du circuit intégré. La tension Vcc est produite à partir des signaux d'antenne S1, S2 (ou l'un des signaux d'antenne S1, S2 si l'un des brins W1, W2 est relié à la masse). Le circuit PSCT est par exemple une pompe de charges primaire qui utilise les signaux alternatifs S1, S2 comme signaux de pompage. La tension Vcc est typiquement de l'ordre du Volt à quelques Volt, les technologies les plus récentes dans le domaine de la microélectronique permettant réaliser des circuits intégrés de faible encombrement, implantés sur une microplaquette de silicium d'une surface inférieure au mm² et fonctionnant avec une tension d'alimentation de l'ordre de 1,8 V.

Le circuit de modulation MCT reçoit de l'unité de contrôle CTU1 des données DTx à émettre, généralement sous forme codée, et module l'impédance du circuit d'antenne AC en fonction de ces données, ici en appliquant au circuit PSCT un signal de modulation d'impédance S(DTx) ayant pour effet de court-circuiter des étages de la pompe de charges primaire.

Le circuit DCT démodule les signaux S1, S2 et fournit à l'unité CTU1 des données DTr véhiculées par ces signaux. De telles données sont envoyées par le lecteur RD1 par modulation du champ électrique E, par exemple une modulation de l'amplitude du champ électrique.

Le circuit survolteur HVCT comprend ici une pompe de charges PMP et un circuit HGEN assurant l'excitation de la pompe de charges. Le circuit HGEN fournit à la pompe de charges deux signaux de pompage H1, H2 basse fréquence et en opposition de phase, générés à partir du signal d'horloge CK. La pompe de charges PMP fournit une haute tension Vhv, typiquement de 10 à 15 V, à partir de la tension Vcc (ou directement à partir des signaux d'antenne S1, S2). La tension Vhv est appliquée à la mémoire MEM par l'intermédiaire d'un circuit interrupteur SCT. Le circuit SCT est ici un générateur de rampe permettant d'appliquer progressivement la tension Vhv à la mémoire MEM pendant des phases d'écriture, afin de ne pas endommager les cellules mémoire. La haute tension fournie sous forme de rampe à la sortie du circuit interrupteur SCT est désignée ici Vpp.

L'unité de contrôle CTU2 reçoit ainsi du lecteur RD1, par l'intermédiaire du circuit d'antenne AC et du circuit d'interface CICT, des commandes de lecture ou d'écriture de la mémoire MEM incluant une adresse d'écriture ADW ou de lecture ADR, les commandes d'écriture comprenant en outre des données à écrire DTW. Elle renvoie des messages pouvant contenir des données DTR lues dans la mémoire, notamment en réponse à une commande de lecture. L'écriture d'une donnée comprend généralement l'effacement de cellules mémoire désignées par l'adresse reçue, correspondant à l'écriture d'un "0" dans les cellules mémoire, puis la programmation des cellules mémoire devant recevoir un "1".

Lorsqu'une commande d'écriture est reçue, l'unité CTU2 active le circuit HGEN afin que la pompe de charges PMP reçoive les signaux de pompage H1, H2 et fournisse la tension Vhv. Ensuite, l'unité CTU2 applique à la mémoire l'adresse d'écriture ADW et les données à écrire DTW, puis active le circuit interrupteur SCT pour qu'une impulsion de tension Vpp soit appliquée à la mémoire. Ici, l'unité CTU2 active le circuit HGEN en appliquant sur une entrée de contrôle de ce circuit un signal "ON1" égal à 1, et active le circuit interrupteur SCT en appliquant sur une entrée de contrôle de ce circuit un signal "WRITE" égal à 1.

Selon l'invention, le circuit intégré IC2 comprend un circuit détecteur de seuil THDET qui surveille la haute tension Vhv et comporte à cet effet une entrée connectée à la sortie de la pompe de charges PMP. Le circuit THDET comporte également une sortie qui fournit un signal de détection THR1. Le signal THR1 est par défaut à 0 lorsque la haute tension Vhv est inférieure à un seuil Vc. Lorsque la tension Vhv dépasse le seuil Vc, le circuit THDET met le signal THR1 à 1.

Selon l'invention, le seuil Vc est un seuil critique à partir duquel le circuit survolteur HVCT est supposé avoir accumulé suffisamment de charges électriques pour assurer une opération d'écriture de la mémoire MEM, même en cas d'affaiblissement ou de microcoupures de la tension d'alimentation Vcc.

Le circuit intégré IC2 comprend également un point mémoire volatile pour mémoriser un drapeau indicateur THR2. Ce point mémoire est ici une bascule FF1 qui reçoit le signal THR1 sur une entrée SET et dont la sortie fournit le drapeau THR2. Après remise à zéro de la bascule FF1, le drapeau THR2 passe à 1 la première fois que le signal THR1 passe à 1, puis reste égal à 1 jusqu'à la remise à zéro suivante de la bascule. Cette remise à zéro est assurée en appliquant sur une entrée RESET de la bascule un signal /ON1 fourni par une porte inverseuse recevant le signal ON1 en entrée. Ainsi, lorsque le signal ON1 est maintenu à 0 par l'unité de contrôle CTU2 et que le circuit survolteur HVCT est désactivé, le drapeau THR2 est forcé à 0. Lorsque l'unité CTU2 met le signal ON1 à 1 pour activer le circuit HVCT, la valeur du drapeau reste à 0. Lorsque la tension Vhv atteint le seuil Vc, le signal THR1 passe à 1 le drapeau THR2 passe à 1.

Selon un aspect optionnel mais avantageux de l'invention, la tension Vhv est régulée autour d'un seuil de régulation qui est ici égal au seuil critique Vc. Toujours de façon avantageuse, cette régulation est assurée ici en inhibant le circuit HGEN lorsque le signal THR1 passe à 1, de manière que les signaux de pompage H1, H2 ne soient plus fournis à la pompe de charges. L'entrée de contrôle du circuit HGEN est par exemple reliée à la sortie d'une porte A1 de type ET qui reçoit le signal ON1 sur une entrée non inverseuse et le signal THR1 sur une entrée inverseuse. Lorsque le signal ON1 est égal à 1 et le signal THR1 égal à 0 (Vhv < Vc), la porte A1 est transparente vis-à-vis du signal ON1 et le circuit HGEN est activé. Lorsque le signal THR1 passe à 1 (Vhv ≥ Vc), la sortie de la porte A1 passe à 0 et le circuit HGEN est désactivé, de sorte que la tension Vhv diminue jusqu'à ce que le signal THR1 repasse à 0 (Vhv < Vc). Puis, la tension Vhv augmente de nouveau et le signal THR1 repasse à 1, et ainsi de suite, la tension Vhv étant ainsi régulée au voisinage du seuil Vc.

Ainsi, le détecteur THR1 forme avantageusement, avec la porte A1, un régulateur de la haute tension Vhv, en sus de sa fonction de détection du seuil permettant de gérer le drapeau THR2. L'homme de l'art notera qu'une telle régulation du circuit survolteur par inhibition du circuit HGEN économise la consommation électrique du circuit intégré et est plus avantageuse qu'une régulation par écrêtage de la haute tension Vhv sans arrêter la pompe de charges, impliquant l'apparition d'un courant de fuite dans le régulateur. De même, l'inhibition des signaux H1, H2 pourrait être envisagée sans arrêter le circuit HGEN, mais celui-ci consommerait du courant inutilement.

Selon un autre aspect optionnel mais avantageux de l'invention, le circuit interrupteur SCT ne peut pas être déclenché par l'unité de contrôle CTU tant que la haute tension Vhv n'a pas atteint au moins une fois le seuil critique Vc après l'activation du circuit survolteur HVCT. A cet effet, l'entrée de contrôle du circuit interrupteur SCT est par exemple reliée à la sortie d'une porte A2 de type ET recevant le signal WRITE sur une première entrée et recevant le drapeau THR2 sur une seconde entrée. Lorsque le signal WRITE est mis à 1 par l'unité CTU2 pour appliquer une impulsion de tension Vpp à la mémoire, la porte A1 n'est pas transparente vis-à-vis du signal WRITE tant que le drapeau THR2 n'est pas égal à 1.

Ainsi, si un affaiblissement de la tension d'alimentation Vcc empêche la haute tension Vhv de croître de manière prévue et si celle-ci n'atteint pas le seuil Vc au moment où l'unité de contrôle met à 1 le signal WRITE, l'inhibition du circuit interrupteur SCT garantit que la mémoire MEM ne va pas recevoir une tension Vpp d'un niveau insuffisant pour écrire les données et pouvant entraîner une corruption de données.

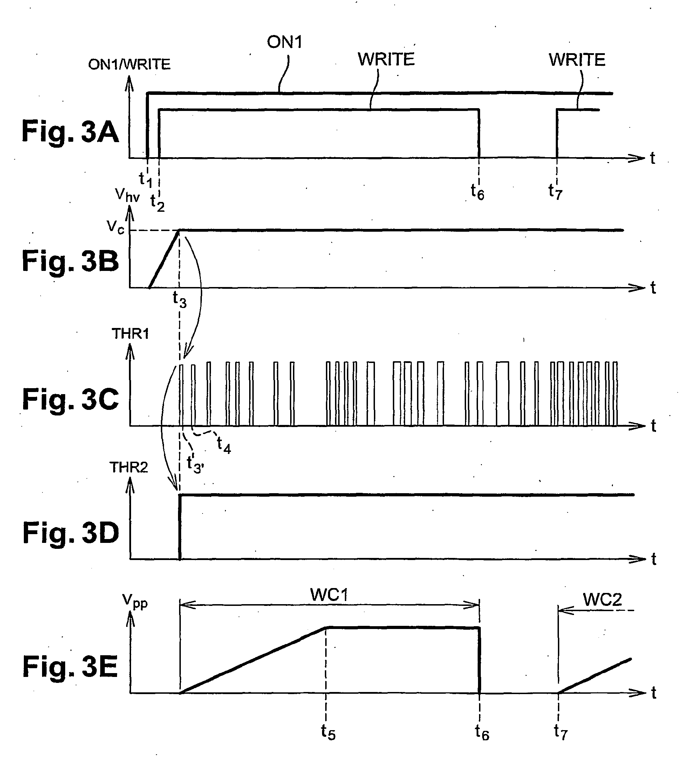

Les figures 3A à 3E représentent l'aspect des signaux ON1, WRITE, THR1, du drapeau THR2 et des tensions Vhv, Vpp pendant une phase d'écriture de la mémoire comprenant des cycles d'écriture WC1, WC2,... de la mémoire. Les signaux ON1 et WRITE sont représentés en figure 3A, la tension Vhv est représentée en figure 3B (les variations de la tension Vhv dues à la régulation autour du seuil Vc n'étant pas représentées), le signal THR1 est représenté en figure 3C (ici en tant que signal de détection et signal de régulation de la tension Vhv), le drapeau THR2 est représenté en figure 3D et la tension Vpp fournie par le circuit interrupteur SCT en tant que générateur de rampe est représenté en figure 3E.

On entend par "cycle d'écriture" WC1, WC2 un cycle d'effacement ou de programmation d'une ou plusieurs cellules mémoire, et par "phase d'écriture" une période couvrant l'ensemble des cycles d'effacement et de programmation nécessaires à l'enregistrement d'une donnée. Par exemple, si la mémoire MEM est effaçable par mots de 8 bits et programmable par mots de 8 bits et que la donnée à écrire est un mot, la phase d'écriture du mot comprend un cycle d'effacement de huit cellules mémoire (cycle d'effacement collectif, écriture d'un 0 dans les cellules mémoire) et un cycle de programmation collective des cellules mémoire devant recevoir un 1. Si la mémoire MEM est effaçable par page (ligne de mot) ou par secteur et est programmable par mots de 8 bits, et si la donnée à écrire comprend plusieurs mots appartenant au même secteur ou à la même page, la phase d'écriture des mots comprend un cycle d'effacement collectif de tout le secteur ou de toute la page, et autant de cycles de programmation que de mots à écrire.

A un instant t0 précédant le premier cycle d'écriture WC1, par exemple un cycle d'effacement, les signaux ON1 et WRITE sont à 0, la tension Vhv est nulle, le signal THR1 est égal à 0 et le drapeau THR2 est maintenu à 0 par le signal ON1 (agissant sur l'entrée RESET de la bascule FF1). A un instant t1, l'unité CTU2 met le signal ON1 à 1 et la tension Vhv commence à monter. A un instant t2, l'unité CTU2 met le signal WRITE à 1 mais le circuit interrupteur SCT reste bloqué car le drapeau THR2 est égal à 0 et inhibe l'application du signal WRITE sur l'entrée de contrôle du circuit SCT. A un instant t3, la tension Vhv atteint le seuil Vc et le signal THR1 passe pour la première fois à 1 depuis la mise sous tension du circuit survolteur, de sorte que le drapeau THR2 passe également à 1. Le circuit SCT se déclenche et une rampe de tension Vpp est appliquée à la mémoire MEM. Simultanément, le signal ON1 est inhibé à l'entrée du circuit survolteur et la haute tension Vhv diminue. A un instant t3', la tension Vhv repasse en dessous du seuil Vc et le signal THR1 repasse à 0. A un instant t4, la tension Vhv atteint le seuil Vc et le signal THR1 repasse à 1, puis repasse à 0 à un instant t4', etc., ces alternances dues à la régulation de la tension Vhv n'affectant pas le drapeau THR2 qui reste à 1 pendant toute la durée de la phase d'écriture, tant que le signal ON1 reste à 1. A un instant t5, la tension Vpp atteint un plateau égal à Vc (ou Vc-Vm si le circuit SCT impose une diminution de tension Vm à la tension Vhv) et reste stable au voisinage du plateau jusqu'à un instant t6 qui marque la fin du cycle d'écriture WC1, où l'unité CTU2 met le signal WRITE à 0 tout en laissant le signal ON1 à 1. Le signal THR1 continue de passer alternativement de 0 à 1 et vice-versa pour réguler la haute tension Vhv, et le drapeau THR2 reste à 1. A un instant t7, l'unité CTU2 remet le signal WRITE à 1 et le second cycle d'écriture WC2 est engagé, par exemple un cycle de programmation. Le drapeau THR2 est ici à 1 dès le commencement du cycle WC2 et reste à 1 pendant toute la phase d'écriture.

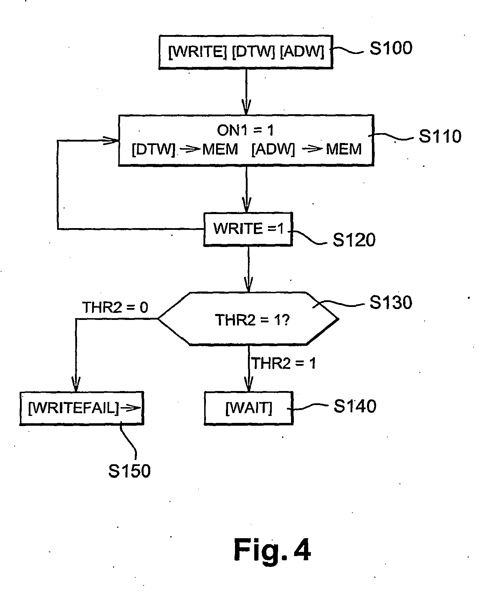

La figure 4 est un organigramme décrivant l'exécution de la phase d'écriture par l'unité, de contrôle CT2 et l'utilisation du drapeau THR2 pour diagnostiquer une éventuelle défaillance de la haute tension Vhv. Au cours d'une étape S100, l'unité CTU2 reçoit du lecteur RD1 une commande "[WRITE] [DTW] [ADW]". Au cours d'une étape S110, l'unité CTU2 met le signal ON1 à 1 pour activer le circuit survolteur (instant t1 décrit plus haut) et applique la donnée DTW et l'adresse ADW à la mémoire. Au cours d'une étape S120, l'unité CTU2 met à 1 le signal WRITE (instant t2 décrit plus haut). Les étapes S110 et S120 peuvent être répétées en boucle autant de fois que le nombre de cycles d'écriture CW1, CW2... à effectuer, en laissant le signal ON1 à 1.

Une fois la phase d'écriture terminée, l'unité CTU2 teste le drapeau THR2 au cours d'une étape S130 :
- si le drapeau THR2 est égal à 1, la phase d'écriture est supposée s'être déroulée normalement et l'unité CTU2 passe à une étape S140 ("WAIT") où elle attend une nouvelle commande. Dans une variante, l'unité CTU2 lit les données qu'elle a écrites dans la mémoire et les renvoie dans un message de confirmation d'exécution de la commande avant de passer à l'étape S140, afin que le lecteur RD1 puisse vérifier que les données écrites sont bien celles qui figuraient dans la commande,
- si le drapeau THR2 est égal à 0, cela signifie que la haute tension Vhv n'a pas atteint le seuil critique et que la mémoire n'a pas été écrite. L'unité CTU2 passe à une étape S150 où elle envoie un message d'échec "WRITEFAIL". Comme précédemment, il peut être prévu que l'unité CTU2 lise les données dans la mémoire à l'adresse d'écriture ADW qui figurait dans la commande, et les renvoie au lecteur RD1 avec le message WRITEFAIL afin que celui-ci puisse vérifier que des données corrompues n'ont pas été écrites. Toutefois, un avantage du drapeau THR2 selon l'invention est de permettre au circuit intégré d'envoyer rapidement une information d'échec d'écriture sans qu'il soit nécessaire de relire la zone mémoire, grâce à un diagnostic d'échec fiable basé sur l'observation de la tension Vhv et non l'observation de la tension Vcc.

L'homme de l'art notera que l'utilisation du drapeau indicateur THR2 pour inhiber automatiquement l'activation du circuit générateur de rampe SCT est un aspect de l'invention qui est particulièrement avantageux lorsque le circuit intégré IC2 est équipé d'une unité de contrôle CTU à logique câblée comprenant une machine à nombre d'états fini ("Finite State Machine") qui cadence les cycles d'écriture selon un séquencement figé cadencé par le signal d'horloge CK. La prévision d'une unité de contrôle gérée à logique câblée permet de réaliser des circuits intégrés à faible coût pour les applications de masse.

L'invention est toutefois susceptible de diverses variantes de réalisation selon le niveau "d'intelligence" et d'adaptabilité de l'unité de contrôle. Par exemple, une unité de contrôle à microprocesseur peut tester le drapeau THR2 avant d'appliquer le signal d'activation WRITE au circuit interrupteur SCT. Dans ce cas, l'inhibition du signal WRITE au moyen du drapeau THR2 n'est pas nécessaire. L'unité de contrôle attend que le drapeau THR2 passe à 1 pendant un laps de temps mesuré au moyen d'un timer (minuterie) et, si le laps de temps est écoulé sans que la tension Vhv n'ait atteint le seuil critique Vc, l'unité de contrôle annule le cycle d'écriture et envoie le message WRITEFAIL.

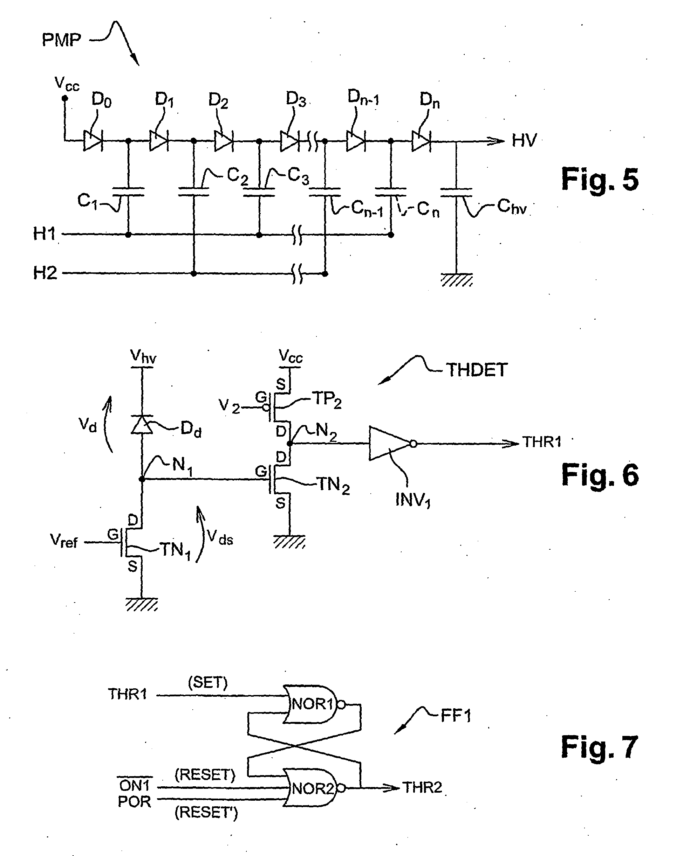

La figure 5 représente un exemple classique de réalisation de la pompe de charges PMP. Celle-ci comprend des condensateurs C1, C2...Cn en parallèle, l'anode de chaque condensateur étant reliée à l'anode du condensateur de rang suivant par une diode D1, D2...Dn-1, la cathode de chaque condensateur de rang impair recevant le signal de pompage H1 et la cathode de chaque condensateur de rang pair recevant le signal de pompage H2. Une diode Dn relie l'anode du dernier condensateur à un condensateur de sortie Chv fournissant la tension Vhv, et la tension Vcc est appliquée à l'anode du premier condensateur C1 par l'intermédiaire d'une diode D0. Lorsque le signal H1 est à l'état haut et le signal H2 à l'état bas, chaque condensateur de rang impair déverse dans le condensateur de rang pair suivant les charges accumulées au cours du demi-cycle précédent où le signal H2 était à l'état haut et le signal H1 à l'état bas. Lorsque le signal H2 est à l'état haut et le signal H1 à l'état bas, chaque condensateur de rang pair déverse dans le condensateur de rang impair suivant les charges accumulées au cours du demi-cycle précédent où le signal H1 était à l'état haut et le signal H2 à l'état bas.

La figure 6 représente un exemple de réalisation du circuit de détection THDET. Celui-ci comprend un étage d'entrée formé par une diode Dd reliée à la borne de drain d'un transistor NMOS TN1 dont la borne de source est connectée à la masse. La diode Dd est montée en inverse et reçoit la tension Vhv. Le transistor TN1 reçoit sur sa grille G une tension de polarisation Vref stable et de préférence compensée en température. La diode Dd présente une tension inverse Vd et le transistor présente une tension drain-source Vds imposée par la tension Vref. Un noeud N1 situé sur le drain du transistor TN1 est appliqué sur la grille d'un transistor NMOS TN2 ayant sa borne de source S reliée à la masse. La borne de drain D de ce transistor forme un noeud N2 qui est appliqué à l'entrée d'une porte inverseuse INV1 dont la sortie fournit le signal de détection THR1. Le noeud N2 est polarisé à l'état haut par un transistor PMOS TP2 dont la borne de source S reçoit la tension Vcc et dont la grille reçoit une tension V2. Lorsque la tension Vhv atteint le seuil Vc, égal ici Vd+Vds, l'étage d'entrée devient conducteur et le noeud N1 passe du potentiel haute impédance au potentiel Vds. Le transistor TN2 devient passant et le noeud N2 passe de 1 (Vcc) à 0 (masse). Le signal THR1 passe à 1.

La figure 7 représente un exemple de réalisation de la bascule FF1 au moyen de deux portes NOR1, NOR2 (portes NON OU), chaque porte ayant sa sortie ramenée sur une entrée de l'autre porte. Une autre entrée de la porte NOR1 forme l'entrée SET de la bascule et reçoit le signal THR1. Une autre entrée de la porte NOR2 forme l'entrée RESET de la bascule et reçoit le signal /ON1, comme décrit plus haut. La sortie de la porte NOR2 fournit le drapeau THR2. Optionnellement, la porte NOR2 comprend une troisième entrée formant une entrée RESET' de la bascule et recevant un signal POR ("Power On Reset") qui est généré par le circuit intégré à chaque mise sous tension.

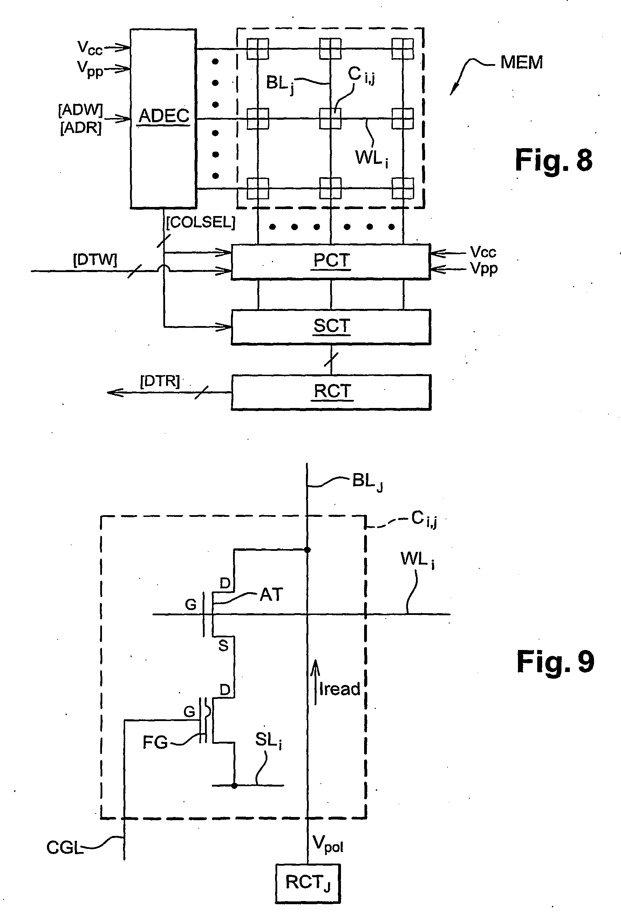

La figure 8 représente schématiquement un exemple de réalisation de la mémoire MEM. La mémoire MEM comprend un plan mémoire MA, un décodeur d'adresse ADEC, un circuit de programmation PCT, un circuit de sélection SCT et un circuit de lecture RCT. Le plan mémoire MA comprend des cellules mémoire Ci,j effaçables et programmables électriquement agencées selon des lignes horizontales et verticales et reliées à des lignes de mot WLi et à des lignes de bit BLj. Le circuit de programmation PCT comprend des verrous d'effacement-programmation (non représentés) reliés aux lignes de bit du plan mémoire, sélectionnés par un signal COLSEL fournit par le décodeur ADEC et recevant les données DTW à écrire dans le plan mémoire. Le circuit de lecture RCT comprend un ou plusieurs amplificateurs de lecture reliés aux lignes de bits du plan mémoire MA par l'intermédiaire du circuit de sélection SCT et fournissant les données DTR lues dans le plan mémoire.

La figure 9 représente un exemple de réalisation d'une cellule mémoire Ci,j effaçable et programmable électriquement permettant de stocker un bit bi,j dans le plan mémoire. La cellule mémoire comprend un transistor à grille flottante FGT et un transistor d'accès AT, ici de type NMOS. Le transistor d'accès a une borne de drain D connectée à une ligne de bit BLj, une grille G connectée à une ligne de mot WLi et une borne de source S connectée à une borne de drain D du transistor FGT. Ce dernier comporte en outre une grille flottante FG, une grille de contrôle CG reliée à une ligne de contrôle de grille CGL, et une borne de source S reliée à une ligne de source SLi. La cellule mémoire Ci,j est mise dans l'état programmé en appliquant par exemple la tension Vpp sur la borne de drain D du transistor FGT, via le transistor d'accès AT, et une tension de plus faible valeur, par exemple 0V, sur sa grille de contrôle CG. Des charges électriques sont injectées dans la grille flottante FG par effet tunnel et font baisser la tension de seuil Vt du transistor FGT, qui devient généralement négative. La cellule mémoire Ci,j est mise dans l'état effacé en appliquant par exemple la tension Vpp sur la grille de contrôle CG du transistor FGT et une tension de plus faible valeur, par exemple 0V, sur sa borne de source S. Des charges électriques sont extraites de la grille flottante FG par effet tunnel et la tension de seuil du transistor FGT augmente pour devenir généralement positive.

La lecture de la cellule mémoire Ci,j est assurée par un amplificateur de lecture RCTj relié à la borne de drain D du transistor FGT via la ligne de bit BLj et le transistor d'accès AT. L'amplificateur RCTj applique à la ligne de bit une tension de polarisation Vpol pendant qu'une tension de lecture Vread est appliquée sur la grille de contrôle CG du transistor FGT et que la ligne de source est portée à la masse. Si le transistor FGT est dans l'état programmé, la cellule mémoire est passante et un courant de lecture Iread supérieur à un seuil déterminé traverse la ligne de bit BLj. L'amplificateur RCTj. fournit alors un bit bi,j dont la valeur est définie par convention, par exemple 1. Si le transistor FGT est dans l'état effacé, la cellule mémoire n'est pas passante ou est faiblement passante et l'amplificateur RCTj fournit un bit bi,j de valeur inverse, par exemple un bit égal à 0.

L'utilisation d'une telle mémoire EEPROM ayant des cellules effaçable et programmable électriquement par effet tunnel est avantageuse car l'injection et l'extraction de charges par effet tunnel s'effectuent avec un courant très faible, contrairement aux mémoires où l'injection de charges s'effectue par injection de porteurs chauds et nécessite un courant de cellule important. Une telle mémoire satisfait ainsi le principe de base sur lequel l'invention repose, selon lequel le processus d'écriture doit généralement se dérouler correctement même en présence d'un affaiblissement de la tension Vhv, dès lors que le seuil critique Vc est atteint. En pratique, et comme cela ressort de ce qui précède, le seuil Vc est de préférence choisi égal ou proche du seuil de régulation du circuit survolteur, qui est généralement de l'ordre de 10 à 15 V selon la technologie utilisée pour réaliser les cellules mémoire.

Il apparaîtra clairement à l'homme de l'art que les moyens de surveillance de la haute tension Vhv et de gestion du drapeau indicateur THR2 sont susceptibles de diverses variantes de réalisation. La présente invention est également susceptible de diverses applications et n'est pas uniquement destinée aux circuits sans contact UHF fonctionnant par couplage électrique. L'invention d'applique notamment aux circuits intégrés à couplage inductif et s'applique de façon générale à tout circuit intégré ou transpondeur dont l'alimentation électrique est susceptible de faiblir pendant des phases de programmation ou d'effacement de cellules mémoire.

## Revendications

1. Circuit intégré passif sans contact (IC2) comprenant une mémoire de données non volatile (MEM) programmable électriquement, un circuit survolteur à accumulation de charges (HVCT, PMP, HGEN) pour fournir une haute tension (Vhv) nécessaire à l'écriture de données (DTW) dans la mémoire, **caractérisé en ce qu'**il comprend :
- un point mémoire volatile (FF1) pour mémoriser un drapeau indicateur (THR2), et
- des moyens (THDET, THR1, FF1) pour modifier la valeur du drapeau indicateur (THR2) lorsque la haute tension (Vhv) atteint la première fois un seuil critique (Vc) après activation du circuit survolteur.

2. Circuit intégré selon la revendication 1, comprenant un circuit interrupteur (SCT) pour appliquer la haute tension (Vhv) à la mémoire (MEM) et des moyens (A2) pour empêcher le circuit interrupteur (SCT) d'appliquer la haute tension à la mémoire (MEM) tant que la haute tension n'a pas atteint le seuil critique (Vc) après activation du circuit survolteur.

3. Circuit intégré selon la revendication 2, dans lequel le circuit interrupteur (SCT) comprend un générateur de rampe pour fournir progressivement la haute tension (Vhv) à la mémoire (MEM).

4. Circuit intégré selon l'une des revendications 1 à 3, comprenant une unité de contrôle (CTU2) configurée pour exécuter une commande d'écriture d'une donnée (DTW) dans la mémoire (MEM) puis émettre un message d'information spécifique (WRITEFAIL) quand le drapeau (THR2) indique que la haute tension (Vhv) n'a pas atteint le seuil critique (Vc) pendant l'exécution de la commande d'écriture.

5. Circuit intégré selon l'une des revendications 1 à 4, comprenant une unité de contrôle (CTU2) configurée pour effectuer de façon inconditionnelle les actions suivantes, en réponse à une commande d'écriture d'une donnée (DTW) dans la mémoire (MEM):
- appliquer un signal d'activation (ON1=1) au circuit survolteur (HVCT, HGEN, PMP) pour qu'il produise la haute tension (Vhv),
- appliquer à la mémoire une adresse d'écriture (ADW) et une donnée (DTW) à écrire, et
- appliquer un signal d'activation (WRITE=1) à un circuit interrupteur (SCT) fournissant la haute tension (Vhv) à la mémoire.

6. Circuit intégré selon l'une des revendications 1 et 2, comprenant une unité de contrôle (CTU2) configurée pour effectuer les actions suivantes, sur réception d'une commande d'écriture d'une donnée (DTW) dans la mémoire (MEM) :
- appliquer un signal d'activation (ON1=1) au circuit survolteur (HVCT, HGEN, PMP), pour qu'il produise la haute tension (Vhv),
- appliquer à la mémoire une adresse d'écriture (ADW) et la donnée (DTW) à écrire,
- si la haute tension atteint le seuil critique (Vc), appliquer un signal d'activation (WRITE=1) à un circuit interrupteur (SCT) fournissant la haute tension (Vhv) à la mémoire, et
- si la haute tension n'a pas atteint le seuil critique (Vc) au terme d'un intervalle de temps déterminé, ne pas appliquer le signal d'activation (WRITE=1) au circuit interrupteur (SCT) et émettre un message d'information spécifique (WRITEFAIL) indiquant que la haute tension (Vhv) n'a pas été appliquée à la mémoire.

7. Circuit intégré selon l'une des revendications 1 à 6, comprenant un circuit détecteur (THDET) qui surveille la haute tension et fournit un signal de détection (THR1) dont la valeur indique si la haute tension (Vhv) est inférieure au seuil critique (Vc) ou est supérieure ou égale au seuil critique (Vc).

8. Circuit intégré selon l'une des revendications 1 à 7, comprenant un circuit régulateur (THDET, A1) fournissant un signal de régulation (THR1) du circuit survolteur ayant une valeur active (1) chaque fois que la haute tension (Vhv) est supérieure ou égale à un seuil de régulation (Vc).

9. Circuit intégré selon la revendication 8, dans lequel le seuil critique est égal au seuil de régulation (Vc).

10. Circuit intégré selon la revendication 7 et l'une des revendications 8 et 9, dans lequel le signal de régulation (THR1) et le signal de détection (THR1) sont confondus.

11. Circuit intégré selon l'une des revendications 1 à 9, dans lequel le drapeau indicateur (THR2) est mémorisé par une bascule (FF1) comprenant une première entrée de contrôle (SET) pour conférer au drapeau (THR2) une première valeur (1) signifiant que la haute tension (Vhv) a atteint le seuil critique (Vc), et une seconde entrée de contrôle (RSET) pour conférer au drapeau une seconde valeur signifiant que la haute tension (Vhv) n'a pas atteint le seuil critique (Vc).

12. Circuit intégré selon les revendications 7 et 11, dans lequel la première entrée de contrôle (SET) de la bascule reçoit le signal de détection (TH1).

13. Circuit intégré selon l'une des revendications 11 et 12, dans lequel la seconde entrée (RSET) de la bascule reçoit au moins l'un des deux signaux suivants : un signal (/ON1) de désactivation du circuit survolteur et/ou un signal (POR) de remise à zéro du circuit intégré.

14. Objet portatif électronique de type carte à puce ou étiquette électronique, comprenant un support portable et un circuit intégré (IC2) selon l'une des revendications 1 à 13 monté sur le support portable ou intégré dans le support portable.

15. Procédé d'écriture d'une donnée (DTW) dans une mémoire non volatile (MEM) programmable électriquement d'un circuit intégré sans contact passif (IC2), **caractérisé en ce qu'**il comprend les étapes consistant à :
- initialiser un drapeau indicateur (THR2) dans un point mémoire volatile (FF1) du circuit intégré,
- activer (ON1=1) un circuit survolteur à accumulation de charges (HVCT, PMP, HGEN) fournissant une haute tension (Vhv) nécessaire à l'écriture de la donnée (DTW) dans la mémoire, et
- changer la valeur du drapeau indicateur (THR2) lorsque la haute tension (Vhv) atteint la première fois un seuil critique (Vc) après activation du circuit survolteur.

16. Procédé selon la revendication 15, dans lequel la haute tension (Vhv) n'est pas appliquée à la mémoire (MEM) tant qu'elle n'atteint pas le seuil critique (Vc).

17. Procédé selon l'une des revendications 15 et 16, comprenant l'exécution inconditionnelle d'étapes prédéfinies visant à écrire la donnée (DTW) dans la mémoire, puis l'envoi d'un message d'information (WRITEFAIL) relatif à la valeur du drapeau indicateur (THR2) si le drapeau (THR2) indique que la haute tension n'a pas atteint le seuil critique (Vc) pendant la réalisation des étapes prédéfinies.

18. Procédé selon l'une des revendications 15 à 17, comprenant une étape de régulation de la haute tension (Vhv) au voisinage d'un seuil de régulation (Vc).

19. Procédé selon la revendication 18, dans lequel le seuil critique (Vc) est égal au seuil de régulation (Vc).

20. Procédé selon l'une des revendications 18 et 19, dans lequel le drapeau indicateur (THR2) est géré au moyen d'une bascule (FF1) comprenant une entrée de contrôle (SET) à laquelle est appliqué un signal de détection (THR1) dont la valeur indique si la haute tension (Vhv) est inférieure au seuil critique (Vc) ou est supérieure ou égale au seuil critique (Vc).

21. Procédé selon la revendication 20, dans lequel la bascule (FF1) est remise à zéro quand le circuit survolteur n'est pas actif.

## Claims

1. Passive contactless integrated circuit (IC2) comprising an electrically programmable non-volatile data memory (MEM), a charge accumulation booster circuit (HVCT, PMP, HGEN) for supplying a high voltage (Vhv) necessary for writing data (DTW) in the memory, **characterised in that** it comprises:
- a volatile memory point (FF1) for memorising an indicator flag (THR2), and
- means (THDET, THR1, FF1) for modifying the value of the indicator flag (THR2) when the high voltage (Vhv) reaches a critical threshold (Vc) for the first time after activating the booster circuit.

2. Integrated circuit according to claim 1, comprising a switch circuit (SCT) for applying the high voltage (Vhv) to the memory (MEM) and means (A2) for preventing the switch circuit (SCT) from applying the high voltage to the memory (MEM) as long as the high voltage has not reached the critical threshold (Vc) after activating the booster circuit.

3. Integrated circuit according to claim 2, wherein the switch circuit (SCT) comprises a ramp generator for progressively supplying the high voltage (Vhv) to the memory (MEM).

4. Integrated circuit according to one of claims 1 to 3, comprising a control unit (CTU2) configured for executing a command for writing a datum (DTW) in the memory (MEM) and then sending a specific message of information (WRITEFAIL) when the flag (THR2) indicates that the high voltage (Vhv) has not reached the critical threshold (Vc) during the execution of the write command.

5. Integrated circuit according to one of claims 1 to 4, comprising a control unit (CTU2) configured for unconditionally performing the following actions, in response to a command for writing a datum (DTW) in the memory (MEM):
- applying an activation signal (ON1=1) to the booster circuit (HVCT, HGEN, PMP) so that it produces the high voltage (Vhv),
- applying to the memory a write address (ADW) and a datum (DTW) to be written, and
- applying an activation signal (WRITE=1) to a switch circuit (SCT) supplying the high voltage (Vhv) to the memory.

6. Integrated circuit according to one of claims 1 and 2, comprising a control unit (CTU2) configured for performing the following actions, upon reception of a command for writing a datum (DTW) in the memory (MEM):
- applying an activation signal (ON1=1) to the booster circuit (HVCT, HGEN, PMP), so that it produces the high voltage (Vhv),
- applying to the memory a write address (ADW) and the datum (DTW) to be written,
- if the high voltage reaches the critical threshold (Vc), applying an activation signal (WRITE=1) to a switch circuit (SCT) supplying the high voltage (Vhv) to the memory, and
- if the high voltage has not reached the critical threshold (Vc) at the end of a determined period of time, not applying the activation signal (WRITE=1) to the switch circuit (SCT) and sending a specific message of information (WRITEFAIL) indicating that the high voltage (Vhv) has not been applied to the memory.

7. Integrated circuit according to one of claims 1 to 6, comprising a detection circuit (THDET) which monitors the high voltage and supplies a detection signal (THR1) which value indicates if the high voltage (Vhv) is lower than the critical threshold (Vc) or is superior or equal to the critical threshold (Vc).

8. Integrated circuit according to one of claims 1 to 7, comprising a regulator circuit (THDET, A1) supplying a regulation signal (THR1) of the booster circuit having an active value (1) each time the high voltage (Vhv) is superior or equal to a regulation threshold (Vc).

9. Integrated circuit according to claim 8, wherein the critical threshold is equal to the regulation threshold (Vc).

10. Integrated circuit according to claim 7 and one of claims 8 and 9, wherein the regulation signal (THR1) and the detection signal (THR1) are the same.

11. Integrated circuit according to one of claims 1 to 9, wherein the indicator flag (THR2) is memorised by a flip-flop (FF1) comprising a first control input (SET) for giving the flag (THR2) a first value (1) meaning that the high voltage (Vhv) has reached the critical threshold (Vc), and a second control input (RSET) for giving the flag a second value meaning that the high voltage (Vhv) has not reached the critical threshold (Vc).

12. Integrated circuit according to one of claims 7 and 11, wherein the first control input (SET) of the flip-flop receives the detection signal (TH1).

13. Integrated circuit according to one of claims 11 and 12, wherein the second input (RSET) of the flip-flop receives at least one of the two following signals: a signal (/ON1) for deactivating the booster circuit and/or a signal (POR) for resetting the integrated circuit.

14. Portable electronic object of the type chip card or electronic tag, comprising a portable support and an integrated circuit (IC2) according to one of claims 1 to 13 mounted onto the portable support or integrated into the portable support.

15. Method for writing a datum (DTW) in an electrically programmable non-volatile memory (MEM) of a passive contactless integrated circuit (IC2), **characterised in that** it comprises the steps of:
- initialising an indicator flag (THR2) in a volatile memory point (FF1) of the integrated circuit,
- activating (ON1=1) a charge accumulation booster circuit (HVCT, PMP, HGEN) supplying a high voltage (Vhv) necessary for writing the datum (DTW) in the memory, and
- changing the value of the indicator flag (THR2) when the high voltage (Vhv) reaches a critical threshold (Vc) for the first time after activating the booster circuit.

16. Method according to claim 15, wherein the high voltage (Vhv) is not applied to the memory (MEM) as long as it does not reach the critical threshold (Vc).

17. Method according to one of claims 15 and 16, comprising the unconditional execution of predefined steps aiming at writing the datum (DTW) in the memory, and then sending a message of information (WRITEFAIL) concerning the value of the indicator flag (THR2) if the flag (THR2) indicates that the high voltage has not reached the critical threshold (Vc) during the execution of the predefined steps.

18. Method according to one of claims 15 to 17, comprising a step of regulating the high voltage (Vhv) around a regulation threshold (Vc).

19. Method according to claim 18, wherein the critical threshold (Vc) is equal to the regulation threshold (Vc).

20. Method according to one of claims 18 and 19, wherein the indicator flag (THR2) is managed by means of a flip-flop (FF1) comprising a control input (SET) to which a detection signal (THR1) is applied which value indicates whether the high voltage (Vhv) is inferior to the critical threshold (Vc) or is superior or equal to the critical threshold (Vc).

21. Method according to claim 20, wherein the flip-flop (FF1) is reset when the booster circuit is not active.

## Patentansprüche

1. Kontaktloser passiver integrierter Schaltkreis (IC2) mit einem nicht flüchtigen Datenspeicher (MEM), der elektrisch programmierbar ist, einem Schaltkreis zum Aufwärtstransformieren mit Ladungsspeichern (HVCT, PMP, HGEN), um eine Hochspannung (Vhv) zu liefern, die für das Schreiben von Daten (DTW) in den Speicher erforderlich ist, **dadurch gekennzeichnet, dass** er Folgendes aufweist:
- einen flüchtigen Speicherpunkt (FF1) zum Speichern eines Anzeigeflags (THR2), und
- Mittel (THDET, THR1, FF1), um den Wert des Anzeigeflags (THR2) zu modifizieren, wenn die Hochspannung (Vhv) zum ersten Mal einen kritischen Schwellenwert (Vc) nach dem Aktivieren des Schaltkreises zum Aufwärtstransformieren erreicht.

2. Integrierter Schaltkreis nach Anspruch 1, der einen Unterbrechungsschaltkreis (SCT) aufweist, um die Hochspannung (Vhv) auf den Speicher (MEM) anzulegen, und Mittel (A2), um den Unterbrechungsschaltkreis (SCT) daran zu hindern, die Hochspannung auf den Speicher (MEM) anzulegen, solange die Hochspannung nicht den kritischen Schwellenwert (Vc) nach dem Aktivieren des Schaltkreises zum Aufwärtstransformieren erreicht hat.

3. Integrierter Schaltkreis nach Anspruch 2, bei dem der Unterbrechungsschaltkreis (SCT) einen Rampengenerator aufweist, um allmählich die Hochspannung (Vhv) zu dem Speicher (MEM) zu liefern.

4. Integrierter Schaltkreis nach einem der Ansprüche 1 bis 3, der eine Steuereinheit (CTU2) aufweist, die konfiguriert ist, um einen Befehl zum Schreiben einer Information (DTW) in den Speicher (MEM) auszuführen und dann eine spezifische Informationsmeldung (WRITEFAIL) zu senden, wenn das Flag (THR2) anzeigt, dass die Hochspannung (Vhv) während des Ausführens des Schreibbefehls nicht den kritischen Schwellenwert (Vc) erreicht hat.

5. Integrierter Schaltkreis nach einem der Ansprüche 1 bis 4, der eine Steuereinheit (CTU2) aufweist, die konfiguriert ist, um unbedingt die folgenden Aktionen als Reaktion auf einen Befehl zum Schreiben einer Information (DTW) in den Speicher (MEM) auszuführen:
- Anlegen eines Aktivierungssignals (ON1=1) auf den Schaltkreis zum Aufwärtstransformieren (HVCT, HGEN, PMP), damit er die Hochspannung (Vhv) erzeugt,
- Anlegen auf den Speicher einer Schreibadresse (ADW) und einer zu schreibenden Information (DTW) und
- Anlegen eines Aktivierungssignals (WRITE=1) auf einen Unterbrechungsschaltkreis (SCT), der die Hochspannung (Vhv) zu dem Speicher liefert.

6. Integrierter Schaltkreis nach einem der Ansprüche 1 und 2, der eine Steuereinheit (CTU2) aufweist, die konfiguriert ist, um die folgenden Aktionen beim Empfang eines Befehls zum Schreiben einer Information (DTW) in den Speicher (MEM) auszuführen:
- Anlegen eines Aktivierungssignals (ON1=1) auf den Schaltkreis zum Aufwärtstransformieren (HVCT, HGEN, PMP), damit er die Hochspannung (Vhv) erzeugt,
- Anlegen auf den Speicher einer Schreibadresse (ADW) und der zu schreibenden Information (DTW),
- wenn die Hochspannung den kritischen Schwellenwert (Vc) erreicht, Anlegen eines Aktivierungssignals (WRITE=1) an eine Unterbrechungsschaltung (SCT), die die Hochspannung (Vhv) zu dem Speicher liefert, und
- wenn die Hochspannung den kritischen Schwellenwert (Vc) nach einem bestimmten Zeitintervall nicht erreicht hat, kein Anlegen des Aktivierungssignals (WRITE=1) auf den Unterbrechungsschaltkreis (SCT) und Senden einer spezifischen Informationsmeldung (WRITEFAIL), die anzeigt, dass die Hochspannung (Vhv) nicht auf den Speicher angelegt wurde.

7. Integrierter Schaltkreis nach einem der Ansprüche 1 bis 6, der einen Erfassungsschaltkreis (THDET) aufweist, der die Hochspannung überwacht und ein Erfassungssignal (THR1) liefert, dessen Wert angibt, ob die Hochspannung (Vhv) kleiner ist als der kritische Schwellenwert (Vc) oder größer oder gleich wie der kritische Schwellenwert (Vc) ist.

8. Integrierter Schaltkreis nach einem der Ansprüche 1 bis 7, der einen Regelschaltkreis (THDET, A1) aufweist, der jedes Mal, wenn die Hochspannung (Vhv) größer oder gleich einem Regelschwellenwert (Vc) ist, ein Regelsignal (THR1) des Schaltkreises zum Aufwärtstransformieren, das einen aktiven Wert (1) hat, liefert.

9. Integrierter Schaltkreis nach Anspruch 8, bei dem der kritische Schwellenwert gleich dem Regelschwellenwert (Vc) ist.

10. Integrierter Schaltkreis nach Anspruch 7 und einem der Ansprüche 8 und 9, bei dem das Regelsignal (THR1) und das Erfassungssignal (THR1) zusammenfallen.

11. Integrierter Schaltkreis nach einem der Ansprüche 1 bis 9, bei dem das Anzeigeflag (THR2) von einer Kippschaltung (FF1) gespeichert wird, die einen ersten Steuereingang (SET) aufweist, um dem Flag (THR2) einen ersten Wert (1) zu verleihen, der anzeigt, dass die Hochspannung (Vhv) den kritischen Schwellenwert (Vc) erreicht hat, und einen zweiten Steuereingang (RSET), um dem Flag einen zweiten Wert zu verleihen, der anzeigt, dass die Hochspannung (Vhv) nicht den kritischen Schwellenwert (Vc) erreicht hat.

12. Integrierter Schaltkreis nach den Ansprüchen 7 und 11, bei dem der erste Steuereingang (SET) der Kippschaltung das Erfassungssignal (TH1) empfängt.

13. Integrierter Schaltkreis nach einem der Ansprüche 11 und 12, bei dem der zweite Eingang (RSET) der Kippschaltung mindestens eines der folgenden Signale empfängt: ein Signal (/ON1) zum Deaktivieren des Schaltkreises zum Aufwärtstransformieren und/oder ein Signal (POR) zum Rückstellen des integrierten Schaltkreises auf Null.

14. Tragbares elektronisches Objekt des Typs Chipkarte oder elektronisches Etikett, die/das einen tragbaren Träger und einen integrierten Schaltkreis (IC2) nach einem der Ansprüche 1 bis 13 auf den tragbaren Träger montiert oder in den tragbaren Träger eingebaut aufweist.

15. Verfahren zum Schreiben einer Information (DTW) in einen nicht flüchtigen elektrisch programmierbaren Speicher (MEM) eines integrierten passiven kontaktfreien Schaltkreises (IC2), **dadurch gekennzeichnet, dass** es die folgenden Schritte aufweist:
- Initialisieren eines Anzeigeflags (THR2) in einem flüchtigen Speicherpunkt (FF1) des integrierten Schaltkreises,
- Aktivieren (ON1=1) eines Schaltkreises zum Aufwärtstransformieren mit Speichern von Ladungen (HVCT, PMP, HGEN), der eine Hochspannung (Vhv) liefert, die zum Schreiben der Information (DTW) in den Speicher erforderlich ist und
- Ändern des Werts des Anzeigeflags (THR2), wenn die Hochspannung (Vhv) nach dem Aktivieren des Schaltkreises zum Aufwärtstransformieren zum ersten Mal einen kritischen Schwellenwert (Vc) erreicht.

16. Verfahren nach Anspruch 15, bei dem die Hochspannung (Vhv) nicht auf den Speicher (MEM) angelegt wird, solange sie nicht den kritischen Schwellenwert (Vc) erreicht hat.

17. Verfahren nach einem der Ansprüche 15 und 16, das das unbedingte Ausführen vordefinierter Schritte aufweist, die darauf abzielen, die Information (DTW) in den Speicher zu schreiben, dann Senden einer Informationsmeldung (WRITEFAIL) in Zusammenhang mit dem Wert des Anzeigeflags (THR2), wenn das Flag (THR2) anzeigt, dass die Hochspannung während des Ausführens der vordefinierten Schritte nicht den kritischen Schwellenwert (Vc) erreicht hat.

18. Verfahren nach einem der Ansprüche 15 bis 17, das einen Regelschritt der Hochspannung (Vhv) in der Nähe eines Regelschwellenwerts (Vc) aufweist.

19. Verfahren nach Anspruch 18, bei dem der kritische Schwellenwert (Vc) gleich dem Regelschwellenwert (Vc) ist.

20. Verfahren nach einem der Ansprüche 18 und 19, bei dem das Anzeigeflag (THR2) mittels einer Kippschaltung (FF1) verwaltet wird, die einen Steuereingang (SET) aufweist, auf den ein Erfassungssignal (THR1) angelegt wird, dessen Wert anzeigt, ob die Hochspannung (Vhv) kleiner ist als der kritische Schwellenwert (Vc) oder größer oder gleich wie der kritische Schwellenwert (Vc).

21. Verfahren nach Anspruch 20, bei dem die Kippschaltung (FF1) auf Null zurückgestellt wird, wenn der Schaltkreis zum Aufwärtstransformieren nicht aktiv ist.
